# FASCICULE DE BREVET EUROPEEN

(11) **EP 0 334 709 B1**
(45) Date de publication et mention de la délivrance du brevet: **11.08.1993**
(21) Numéro de dépôt: 89400665.9
(22) Date de dépôt: 10.03.1989
(51) Int. Cl.: H01L 23/48, H01L 23/50, H01L 21/48

(54) **Appareil d'étamage sélectif des conducteurs d'un support de circuit intégré de haute densité et procédé d'étamage utilisant un tel appareil**
Vorrichtung für die selektive Verzinnungen der Leiterbahnen eines Trägers einer integrierten Schaltung mit hoher Dichte und ein eine derartige Vorrichtung verwendendes Verzinnungsverfahren
Apparatus for selective tin-plating of the conductors of a high density integrated support and a tin-plating process utilizing such an apparatus

(30) Priorité: 22.03.1988 FR 8803674
(43) Date de publication de la demande: 27.09.1989
(73) Titulaire: BULL S.A., 92800 Puteaux (FR)
(72) Inventeur: Berneur, Claude, F-75016 Paris (FR); Boiteau, Jean-Pierre, F-75016 Paris (FR)
(74) Mandataire: Denis, Hervé

(56) Documents cités:
- EP-A- 0 193 127
- EP-A- 0 244 666
- FR-A- 2 299 724
- FR-A- 2 570 220
- PATENT ABSTRACTS OF JAPAN, vol. 8, no. 277 (E-285)[1714], 18 décembre 1984, page 67 E 285; & JP-A-59 145 555

## Description

L'invention se rapporte à un appareil d'étamage sélectif des conducteurs d'un support de circuit intégré de haute densité et à un procédé utilisant un tel appareil.

Les circuits intégrés de haute densité, couramment appelés puces ou circuits VLSI (Very Large Scale Integration), sont actuellement de fines plaquettes de matériau semiconducteur sensiblement carrées de plus d'un centimètre de côté, pourvues d'un grand nombre de bornes d'entrée-sortie, de l'ordre de 300 à 400. Selon la technologie TAB (Tape-Automated Bonding) chaque circuit intégré est monté sur un support constitué d'une feuille isolante dans laquelle une fenêtre est pourvue de conducteurs disposés en porte-à-faux pour être reliés à l'intérieur de la fenêtre aux bornes d'entrée-sortie du circuit intégré. Ces bornes sont de ce fait placées à la périphérie du circuit intégré, en ligne ou en quinconce. Ordinairement, la feuille isolante de support forme un ruban souple pourvu de fenêtres successives pour le montage des circuits intégrés et de perforations latérales pour le déplacement et le positionnement du ruban. La terminologie courante désigne ce ruban par ruban TAB et le faisceau des conducteurs disposés en porte-à-faux autour de chaque fenêtre par le terme araignée. La manipulation du support se fait directement sur le ruban TAB ou par l'intermédiaire d'un cadre rigide. Un cadre rigide très employé est du type cadre support de diapositives, tel que décrit par exemple dans les brevets US-A-4 007 479 et 4 069 496. Dans ce cadre, une partie de ruban TAB relative à un circuit intégré et son araignée est positionnée grâce aux perforations latérales du ruban.

Un support TAB de circuit intégré reçoit plusieurs applications. Il sert d'abord au montage d'un circuit intégré sur les extrémités libres intérieures des conducteurs de l'araignée selon une opération appelée ILB (Inner Lead Bonding). On l'utilise ensuite pour faire des tests du circuit intégré, par application des pointes de test sur les plages de contact formées par les extrémités extérieures des conducteurs de l'araignée sur la feuille du support. On distingue les tests simples de vérification des soudures ILB ou du fonctionnement du circuit intégré et les tests élaborés tels que ceux consistant à déterminer la fiabilité dans le temps du circuit intégré par un vieillissement accéléré ("burn-in") Enfin, une application connue d'un support TAB de circuit intégré consiste à découper dans une fenêtre du support les conducteurs de l'araignée pour y prélever le circuit intégré pourvu de ses pattes correspondantes, et à fixer les extrémités de ses pattes sur les plages respectives d'un substrat d'interconnexion tel qu'une carte multicouche de circuits imprimés. Cette opération est désignée par le sigle OLB (Outer Lead Bonding) Actuellement, l'araignée découpée de son support est montée dans un boîtier pour sa connexion OLB à un substrat d'interconnexion. Sur les cartes de circuits imprimés, les plages de connexion et les parties conductrices extérieures sont généralement revêtues d'une couche d'étain-plomb et peuvent donc être facilement soudées à une araignée si celle-ci est adaptée à ce type de soudage. L'adaptation consistait simplement en un étamage uniforme de toute la surface extérieure des pattes de l'araignée. Cependant, l'adaptation des araignées denses actuelles au soudage étain-plomb pose des problèmes.

Le premier problème réside dans l'étamage uniforme d'une araignée destinée à un circuit intégré de haute densité, dont les conducteurs sont nécessairement très étroits et très proches les uns des autres. Par exemple, pour un circuit intégré de plus de 300 bornes d'entrée-sortie, leur pas sur le circuit intégré peut être inférieur à 100 micromètres, et les conducteurs au niveau de la zone de soudage OLB peuvent avoir une largeur de 100 micromètres pour un espacement d'égale valeur. Dans ces conditions, les défauts de recouvrement des conducteurs par l'étain, tels que filaments, pics ou billes, constituent des courts-circuits ou sont susceptibles d'entrer en contact avec les conducteurs adjacents lors des opérations ILB et OLB, qui perturbent légèrement la régularité du pas des conducteurs. La solution actuelle consiste à recouvrir d'or les conducteurs de cuivre par l'intermédiaire de matériaux de liaison tels que le nickel par exemple.

Le second problème posé par un étamage uniforme se rencontre lorsque la connexion ILB de l'araignée se fait sur des boules d'or déposées sur les bornes d'entrée-sortie du circuit intégré. Le soudage eutectique or-étain peut créer des composés intermétalliques altérant les propriétés mécaniques et électriques de la soudure. Ce défaut est d'autant plus indésirable que la soudure a une petite surface. La dorure de l'araignée assure une connexion ILB fiable par thermocompression sur les boules d'or du circuit intégré.

Le troisième problème posé par l'étamage d'une araignée se situe au niveau des plages de contact ménagées aux extrémités extérieures de l'araignée et intervient lors d'un test fonctionnel élaboré, tel que celui effectué après l'épreuve du circuit intégré au vieillissement accéléré (burn-in). Le vieillissement du circuit intégré se traduit par une oxydation ou une altération des plages de contact si elles ne sont pas dorées, et fausse les mesures du test électrique à cause des faux contacts possibles des sondes de test sur les plages.

La solution commune à ces trois problèmes est donc la dorure uniforme des araignées. Cependant, le soudage OLB d'une araignée TAB sur les plages normalement étamées d'une carte de circuits imprimés repose le problème des composés intermétalliques lors du soudage eutectique or-étain. L'adaptation d'une araignée dorée à l'opération OLB sur une carte de circuits imprimés consisterait donc à dorer les plages de la carte avec de l'or ayant la pureté requise pour convenir au soudage par thermocompression. La dorure sélective des cartes de circuits imprimés devrait faire face à des difficultés techniques conduisant le plus souvent à des coûts prohibitifs.

En résumé, un utilisateur voulant disposer de supports TAB de circuits intégrés de haute densité, de grande diffusion et à faible coût, aura le choix entre des araignées nues, sans étamage ou sans dorage, ou des araignées entièrement dorées.

Les documents FR-A-2 299 724 et EP-A-0 244 666 présentent des supports TAB dont les conducteurs portent des zones étamées pour le brasage OLB. La formation sélective de ces zones n'est pas décrite. Le document EP-A-0 193 127 décrit un procédé de formation des zones de contact ILB et OLB sur les conducteurs d'un support TAB. Ce procédé consiste à former ces zones de contact par dépôt électrolytique dans les surfaces gravées d'une couche photorésistive de masquage qui a été déposée sur une feuille métallique uniforme, à éliminer la couche photorésistive de masquage et à graver la feuille métallique pour former les conducteurs du support. Toutes ces phases du procédé s'ajoutent au procédé de fabrication du support TAB et grèvent donc le coût de fabrication du support. De plus, ce procédé ne peut être fait qu'au moment de la fabrication du support et ne laisse donc plus à l'utilisateur la liberté de déterminer l'emplacement de ces zones pour qu'elles correspondent aux plages respectives d'une carte de circuits imprimés d'un type donné.

L'invention présente une solution pour effectuer facilement et à moindre coût l'opération OLB par brasure à base d'étain d'une araignée dense à conducteurs nus ou dorés sur les plages étamées d'un substrat d'interconnexion.

Un appareil conforme à l'invention pour l'étamage d'une zone de conducteurs disposés en porte-à-faux autour d'une fenêtre d'un support de circuit intégré de haute densité est caractérisé en ce qu'il comprend : un étau pour enserrer les conducteurs à l'intérieur de la fenêtre, dont les mâchoires sont creuses et forment en position de serrage une cheminée définissant au niveau des conducteurs la zone à étamer et communiquant avec une source d'étain ; un dispositif pour amener par la cheminée une vague d'étain de façon qu'elle baigne ladite zone des conducteurs pendant une durée prédéterminée ; et des moyens pour envoyer un jet de gaz sur la zone étamée.

L'utilisation de cet appareil peut être faite selon un procédé défini par les caractéristiques de la revendication 6

Les caractéristiques et avantages de l'invention ressortiront de la description qui suit, donnée à titre d'exemple et faite en référence aux dessins annexés.

Dans les dessins :
- la figure 1 est une vue de dessus d'un support de circuit intégré de haute densité, dont les conducteurs sont pourvus d'une zone étamée conforme à l'invention ;
- la figure 2 est une vue en coupe axiale partielle illustrant schématiquement un appareil conforme à l'invention d'étamage sélectif pour le dédorage des conducteurs du support représenté sur la figure 1 ; et
- les figures 3A et 3B sont des vues de détail de l'appareil représenté sur la figure 2 en position d'étamage, illustrant respectivement la phase d'étamage et la phase d'envoi d'un jet de gaz sur la zone étamée du support représenté sur la figure 1.

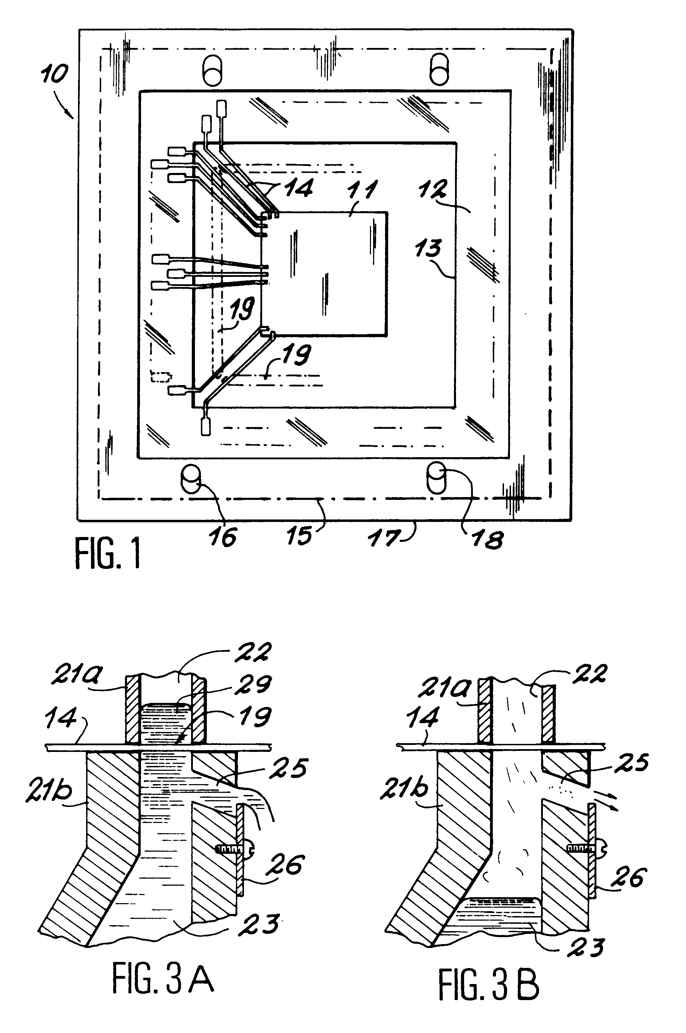

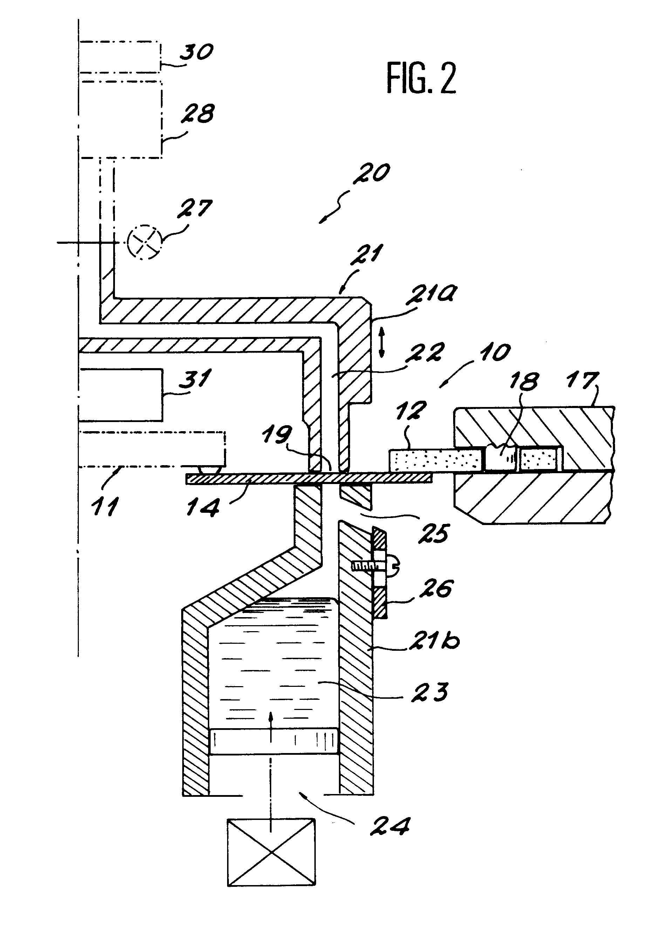

La figure 1 illustre un support 10 d'un circuit intégré de haute densité 11, comprenant une feuille isolante 12 dans laquelle une fenêtre 13 est pourvue de conducteurs dorés 14 disposés en porte-à-faux sur la feuille 12 autour de la fenêtre 13 pour être reliés à l'intérieur de la fenêtre aux bornes du circuit intégré 11. Le faisceau des conducteurs 14 forme l'araignée du support 10, composée de quatre groupes relatifs aux quatre côtés du circuit intégré 11. Les conducteurs 14 se terminent sur la feuille 12 par des plages utilisées pour le test de fonctionnement du circuit intégré 11. Dans l'exemple illustré, la feuille 12 a été découpée, suivant les lignes tiretées de la figure 1, d'un ruban TAB 15 dont les bords sont représentés par un trait mixte. La feuille 12 présente ainsi les perforations latérales 16 du ruban 15. Un cadre rigide 17 fixe la feuille 12 dans une position déterminée par des ergots 18 mis en correspondance avec les perforations 16. Dans le support 10, les conducteurs 14 de l'araignée sont destinés à être découpés dans la fenêtre 13 suivant le bord extérieur d'une zone 19 prévue pour le brasage OLB. La zone 19 se présente sous la forme de quatre bandes étroites, parallèles aux quatre côtés du circuit intégré 11 et formant autour de lui une couronne sensiblement carrée. Dans le support utilisé en pratique, le circuit intégré 11 avait 12 millimètres de côté et portait une araignée de trois cents conducteurs 14, soit 75 conducteurs par côté. La zone 19 constituait une couronne carrée de 24 millimètres de côté et de 3,5 millimètres de largeur. A ce niveau, les conducteurs 14 se succédaient au pas de 317 micromètres tout en étant espacés entre eux de 140 micromètres. Les conducteurs 14 avaient une épaisseur uniforme d'environ 40 micromètres et toute leur surface extérieure était recouverte d'une couche d'or de 1,3 micromètre.

Dans le support 10 la zone 19 prévue pour l'opération OLB est dédorée par étamage. L'étamage est effectué par exemple par l'appareil représenté schématiquement sur la figure 2 suivant une coupe axiale, en position initiale de travail. Les figures 3A et 3B sont des vues en coupe schématique de détail de l'appareil 20 représenté sur la figure 2 au niveau de la zone 19 à dédorer sur le support 10, illustrant respectivement deux phases successives du dédorage qui suivent la phase initiale illustrée dans la figure 2.

L'appareil 20 représenté sur la figure 2, utilisé pour le dédorage de la zone 19 des conducteurs 14 du support 10, comprend un étau 21 dont les deux mâchoires 21a, 21b sont conformées pour enserrer les conducteurs 14 au niveau de la zone à dédorer 19. Plus précisément, les mâchoires 21a, 21b sont creuses pour former, dans la position de serrage telle qu'illustrée, une cheminée 22 composée de quatre compartiments définissant au niveau des conducteurs 14 la zone à étamer 19 et communiquant avec une source d'étain 23. La source d'étain liquide 23 forme dans la mâchoire inférieure 21b une poche compressible grâce à un dispositif de pression 24. De manière classique, l'étain est associé à un flux ou résine de décapage pour assurer le dépôt de l'étain uniformément sur le cuivre des conducteurs. On appellera simplement par la suite étain le mélange utilisé ordinairement pour l'étamage. Le niveau de l'étain au repos dans la poche 23 est relativement distant de l'extrémité haute de la mâchoire inférieure 21b. La cheminée 22 présente entre la source d'étain 23 et la partie haute de la mâchoire inférieure 21b un échappement 25 vers l'extérieur, incliné vers le bas. L'échappement 25 a une ouverture réglable par un dispositif 26 constitué simplement d'une lame traversée de trous oblongs pour être fixée par vis de manière réglable en hauteur sur la paroi extérieure de chaque côté de la mâchoire inférieure 21b. Dans la mâchoire supérieure 21a, la cheminée est en liaison par une vanne 27 avec une source de gaz comprimé 28.

Le dédorage commence par la position de serrage de l'étau 21 représentée sur la figure 2. Dans cette position, les mâchoires 21a, 21b enserrent les conducteurs 14 dans la fenêtre 13 du support 10, et la section de la cheminée 22 définit au niveau des conducteurs 14 la zone à dédorer 19. La vanne 27 de la source de gaz comprimé 28 est fermée et le niveau de l'étain au repos dans la poche 23 est en dessous de l'échappement 25. L'opération de dédorage commence par l'activation du dispositif de pression 24, pour amener par la cheminée 22 une vague d'étain 29 représentée sur la figure 3A. La figure 3A représente la vague d'étain dans sa position haute, dans laquelle elle baigne la zone 19 des conducteurs 14 pendant une durée prédéterminée. L'étain ayant la propriété de dissoudre l'or, l'étamage par la vague 29 réalise le dédorage. La durée de l'étamage dépend de plusieurs facteurs, notamment de l'épaisseur de l'or à éliminer. La hauteur de la vague 29 dans la cheminée 22 et la durée de l'étamage sont réglées par la lame 26 de l'échappement 25 par lequel s'écoule l'étain. Le dispositif de pression 24 est relaché pour que le niveau haut de l'étain revienne en dessous de l'échappement 25, comme illustré dans la figure 3B. Cette figure illustre la troisième phase du dédorage conforme à l'invention, dans laquelle la vanne 27 a été ouverte pour envoyer le gaz comprimé de la source 28 sur la zone 29 qui vient d'être étamée. Le gaz sort par l'échappement 25. Le jet de gaz a essentiellement pour but d'éliminer toute trace d'étain entre les conducteurs 14 pour éviter les courts-circuits entre eux. En chauffant le gaz comprimé à une température légèrement supérieure à la température de fusion de l'étain-plomb, on facilite l'élimination de surcharges d'étain entre conducteurs et on active le flux de décapage mêlé à l'étain afin de laisser sur le cuivre une couche fine et homogène d'étain (de quatre micromètres par exemple) qui facilitera le brasage OLB ultérieur. Le gaz de la source 28 est de préférence un gaz neutre, tel l'azote pour éviter toute oxydation.

L'exemple de réalisation de l'appareil 20 qui vient d'être décrit suggère à l'évidence pour l'homme du métier toutes les variantes de réalisation. Par exemple, la source de gaz comprimé 28 pourrait ne pas être connectée à la cheminée 22. Il suffirait alors de desserrer l'étau 21 juste après la phase d'étamage représentée sur la figure 3A et d'envoyer le gaz comprimé sur les conducteurs 14 libérés de l'étau 21. Dans ce cas, la cheminée 22 pourrait être limitée dans la mâchoire supérieure 21a. D'autre part, l'échappement 25 pourrait ne plus exister. La hauteur de la vague 29 et la durée de l'étamage pourraient en effet être réglées par un autre moyen que l'échappement 25, par exemple par un dispositif de contrôle associé au dispositif de commande de pression 24 de la poche d'étain 23.

De même, d'autres accessoires pourraient être apportés à l'appareil 20 illustré. On pourrait ainsi adjoindre à la source de gaz comprimé 28 un élément de chauffage 30 pour envoyer de l'azote chaud sur l'étain en fusion avant la phase d'étamage illustrée dans la figure 3A. Avantageusement, la température du gaz sera légèrement supérieure à la température de fusion de l'étain-plomb afin d'activer le flux de décapage qui recouvre naturellement la poche d'étain et de rendre ainsi homogène l'étain en fusion lorsque la vague 29 viendra en contact avec les conducteurs 14 et les baignera. D'autre part, l'appareil 20 pourrait comporter un dispositif de refroidissement 31 du circuit intégré 11 au cas où il serait soumis à une chaleur excessive lors du dédorage. Le dispositif de refroidissement pourrait être simplement une source d'air froid dirigée sur le circuit intégré 11 pendant et éventuellement quelque temps après la durée d'enserrement du support 10 dans l'étau 21.

Plus généralement, la zone d'étamage 19 pourrait être apportée sur n'importe quel support 10, dont l'araignée serait par exemple composée de conducteurs 14 nus. D'autre part, l'étamage effectué par l'appareil 20 peut intervenir à tout moment postérieur à la fabrication du support, soit par l'utilisateur bien entendu, soit par le fabricant à la demande d'un utilisateur. Pour le fabricant, l'appareil 20 est efficace, peu cher, rapide, et souple d'utilisation, de sorte que l'étamage à la demande grèverait peu le coût d'un support.

En outre, bien que l'invention illustrée soit appliquée pour des raisons de clarté et de commodité à un support pourvu d'une simple fenêtre, il est évident qu'elle s'applique aussi bien à tout support TAB perfectionné, dont par exemple la fenêtre inclut plusieurs cadres sensiblement carrés comme dans le support décrit dans la demande de brevet français n° 86 04500 et destiné à un boîtier de circuit intégré de haute densité. Ces cadres isolants pouvant être rattachés à la feuille isolante 12 par des pattes alignées sur les diagonales de la fenêtre 13 et formées comme les cadres à partir de la feuille isolante 12, il faut éviter de mettre en présence ces pattes avec l'étain en fusion. Pour satisfaire à cette condition, la zone 19 se compose des quatre bandes illustrées dans la figure 1 et séparées dans les coins de la fenêtre 13, et la cheminée 22 de l'appareil 20 se compose de quatre compartiments correspondants. En pratique, l'appareil 20 illustré est donc adapté à ce type de support TAB. Cependant, il est clair maintenant que la cheminée 22 et la zone 19 pourraient former une couronne continue autour du circuit intégré 11 si le support TAB n'avait pas de telles pattes, tel que support 10 représenté sur la figure 1.

Il est à noter enfin que les bords des mâchoires illustrées 21a, 21b, qui enserrent les conducteurs 14, sont plans et laissent ainsi des espaces ouverts entre conducteurs adjacents. Cependant, compte tenu de la faible épaisseur des conducteurs d'une araignée dense (de l'ordre de 50 micromètres) et de la tension superficielle de l'étain en fusion, celui-ci ne peut normalement pas se répandre en dehors des mâchoires par les espaces inter-conducteurs. Mais il est évident qu'autrement les bords des mâchoires pourraient être conformés ou adaptés de façon à empêcher l'écoulement de l'étain.

## Revendications

1. Appareil (20) pour l'étamage d'une zone (19) de conducteurs (14) disposés en porte-à-faux autour d'une fenêtre (13) d'un support (10) de circuit intégré de haute densité (11), caractérisé en ce qu'il comprend : un étau (21) pour enserrer les conducteurs à l'intérieur de la fenêtre, dont les mâchoires sont creuses (21a, 21b) et forment en position de serrage une cheminée (22) définissant au niveau des conducteurs la zone à étamer (19) et communiquant avec une source d'étain (23) ; un dispositif (24) pour amener par la cheminée une vague d'étain (29) de façon qu'elle baigne ladite zone des conducteurs pendant une durée prédéterminée ; et des moyens (27, 28) pour envoyer un jet de gaz sur la zone étamée.

2. Appareil selon la revendication 1, caractérisé en ce que les moyens (27, 28) envoient le jet de gaz par la cheminée.

3. Appareil selon la revendication 1 ou 2, caractérisé en ce que la cheminée présente un échappement (25) entre la source d'étain (23) et la zone à étamer (19).

4. Appareil selon la revendication 3, caractérisé en ce que l'échappement (25) a une ouverture réglable.

5. Appareil selon l'une des revendications 1 à 4, caractérisé en ce qu'il comporte un élément de chauffage (30) du gaz pour être envoyé à une température légèrement supérieure à la température de fusion de l'étain.

6. Procédé d'étamage d'une zone (19) de conducteurs (14) disposés en porte-à-faux autour d'une fenêtre (13) d'une feuille isolante (12) d'un support (10) de circuit intégré de haute densité (11) en utilisant un appareil selon l'une des revendications 1 à 5, caractérisé en ce qu'il consiste à utiliser des conducteurs (14 ) nus ou entièrement dorés, à amener dans la zone située à l'intérieur de la fenêtre une vague d'étain pendant une durée déterminée pour l'étamage des conducteurs nus ou pour le dédorage des conducteurs dorés, et à envoyer du gaz comprimé sur la zone pour éviter les courts-circuits d'étain entre les conducteurs.

7. Procédé selon la revendication 6, caractérisé en ce qu'il consiste à envoyer le gaz comprimé à une température légèrement supérieure à la température de fusion de l'étain.

8. Procédé selon l'une des revendications 6 ou 7, caractérisé en ce qu'il consiste à utiliser comme gaz comprimé un gaz évitant toute oxydation, tel que l'azote.

9. Procédé selon l'une des revendications 6 à 8, caractérisé en ce que la zone (19) correspond à la zone de brasage OLB.

## Claims

1. An apparatus (20) for tinning a zone (19) of leads (14) disposed in overhanging fashion about a window (13) of a substrate (10) of a vary large scale integrated circuit (11), characterized in that it comprises: a vice (21) for clamping the leads inside the window, the jaws (21a, 21b) of which are hollow, and which, in the locking position form a shaft (22) defining the zone to be tinned (19) at the level at the leads and communicating with a source of tin (23); a device (24) for introducing a wave of tin (29) through the shaft in such a manner that it bathes said zone of leads for a predetermined period of time; and means (27,28) for sending a jet of gas to the tinned zone.

2. An apparatus according to claim 1, characterized in that the means (27,28) send the jet of gas through the shaft.

3. An apparatus according to claim 1 or 2, characterized in that the shaft has a vent (25) between the source of tin (23) and the zone to be tinned (19).

4. An apparatus according to claim 3, characterized in that the vent (25) has a regulatable opening.

5. An apparatus according to one of claims 1 to 4, characterized in that it includes an element (30) for heating the gas to be sent to a temperature slightly greater than the melting temperature of the tin.

6. A method of tinning a zone (19) of leads (14) disposed in overhanging fashion about a window (13) of an insulating layer (12) of a substrate (10) of a very large scale integrated circuit, using an apparatus according to one of claims 1 to 5, characterized in that it consists of using the bare or entirely gilded leads (14) to introduce a wave of tin into the zone situated inside the window for a time determined for the tinning of the bare conductors or the removal of gilt from the gilded conductors, and of sending compressed gas to the zone to avoid short circuits of tin between the leads.

7. A method according to claim 6, characterized in that it consists of sending the compressed gas at a temperature slightly greater than the melting temperature of the tin.

8. A method according to one of claims 6 or 7, characterized in that it consists of using a gas which is completely resistant to oxidation, such as nitrogen, as the compressed gas.

9. A method according to one of claims 6 to 8, characterized in that the zone (19) corresponds to the OLB soldering zone.

## Patentansprüche

1. Vorrichtung (20) zum Verzinnen einer Zone (19) von Leitern (14), die freitragend um ein Fenster (13) eines Trägers (10) einer integrierten Schaltung (11) mit hohem Integrationsgrad angeordnet sind, dadurch gekennzeichnet, daß sie aufweist: einen Schraubstock (21), um die Leiter im Inneren des Fensters einzuspannen, dessen Backen (21a, 21b) hohl sind und in der Klemmstellung einen Schacht (22) bilden, der auf Höhe der Leiter die zu verzinnende Zone (19) begrenzt und mit einer Zinnquelle (23) in Verbindung steht; eine Einrichtung (24), um durch den Schacht eine Zinnwelle (29) so heranzuführen, daß sie die Zone der Leiter während einer vorbestimmten Zeitdauer badet; sowie Mittel (27, 28) um einen Gasstrahl auf die verzinnte Zone zu schicken.

2. Vorrichtung nach Anspruch 1, dadurch gekennzeichnet, daß die Mittel (27, 28) den Gasstrahl durch den Schacht schicken.

3. Vorrichtung nach Anspruch 1 oder 2, dadurch gekennzeichnet, daß der Schacht einen Auslaß (25) zwischen der Zinnquelle (23) und der zu verzinnenden Zone (19) aufweist.

4. Vorrichtung nach Anspruch 3, dadurch gekennzeichnet, daß der Auslaß (25) eine verstellbare Öffnung aufweist.

5. Vorrichtung nach einem der Ansprüche 1 bis 4, dadurch gekennzeichnet, daß sie ein Heizelement (30) für das Gas aufweist, damit es auf eine Temperatur gebracht wird, die leicht über der Schmelztemperatur des Zinns liegt.

6. Verfahren zum Verzinnen einer Zone (19) von Leitern (14), die freitragend um ein Fenster (13) einer Isolierfolie (12) eines Trägers (10) einer integrierten Schaltung (11) mit hoher Integrationsdichte angeordnet sind, wobei eine Vorrichtung nach einem der Ansprüche 1 bis 5 verwendet wird, dadurch gekennzeichnet, daß es darin besteht, blanke oder vollständig vergoldete Leiter (14) zu verwenden, während einer vorbestimmten Zeitdauer an die im Inneren des Fensters gelegene Zone eine Zinnwelle zum Verzinnen der blanken Leiter oder zum Entgolden der vergoldeten Leiter heranzuführen und komprimiertes Gas auf die zone zu schicken, um Zinnkurzschlüsse zwischen den Leitern zu verhindern.

7. Verfahren nach Anspruch 6, dadurch gekennzeichnet, daß es darin besteht, das komprimierte Gas mit einer Temperatur zu schicken, die leicht über der Schmelztemperatur des Zinns liegt.

8. Verfahren nach einem der Ansprüche 6 oder 7, dadurch gekennzeichnet, daß es darin besteht, als komprimiertes Gas ein Gas wie Stickstoff zu verwenden, das jegliche Oxidierung verhindert.

9. Verfahren nach einem der Ansprüche 6 bis 8, dadurch gekennzeichnet, daß die Zone (19) der OLB-Lötzone entspricht.
